# EUROPÄISCHE PATENTSCHRIFT

(11) **EP 3 404 434 B1**
(45) Veröffentlichungstag und Bekanntmachung des Hinweises auf die Patenterteilung: **09.09.2020**
(21) Anmeldenummer: 17171951.1
(22) Anmeldetag: 19.05.2017
(51) Int. Cl.: G01R 33/28, G01R 33/385

(54) **MAGNETRESONANZANLAGE MIT MUSIKNETZWERK**
MAGNETIC RESONANCE SYSTEM WITH MUSIC NETWORK
ÉQUIPEMENT DE RÉSONANCE MAGNÉTIQUE AVEC UN RÉSEAU MUSICAL

(43) Veröffentlichungstag der Anmeldung: 21.11.2018
(73) Patentinhaber: Siemens Healthcare GmbH, 91052 Erlangen (DE)
(72) Erfinder: Popescu, Stefan, 91056 Erlangen (DE); Rinck, Daniel, 91301 Forchheim (DE)

(56) Entgegenhaltungen:
- DE-A1-102014 222 496
- US-A1- 2011 142 250
- POPESCU, S.: "MR synchronous music", PRIOR ART PUBLISHING DISCLOSURE, 18. März 2013 (2013-03-18), Seiten 1-3, XP040573780,
- DAN MA ET AL: "Music-based magnetic resonance fingerprinting to improve patient comfort during MRI examinations", MAGNETIC RESONANCE IN MEDICINE., Bd. 75, Nr. 6, 16. Juli 2015 (2015-07-16), Seiten 2303-2314, XP055314061, US ISSN: 0740-3194, DOI: 10.1002/mrm.25818

## Beschreibung

Die Erfindung betrifft eine Magnetresonanzanlage zur Magnetresonanzuntersuchung eines Patienten, aufweisend eine Magnetresonanzeinrichtung mit einem Gradientenspulensystem. Daneben betrifft die Erfindung ein Verfahren zum Betrieb einer solchen Magnetresonanzanlage.

Die Magnetresonanzbildgebung ist eine inzwischen etablierte medizinische Bildgebungstechnik an Patienten, die in einer Vielzahl von Anwendungsbereichen einsetzbar ist. Zur Ortskodierung der Magnetresonanzsignale werden hierbei Gradientenspulen eines Gradientenspulensystems der verwendeten Magnetresonanzeinrichtung eingesetzt. Um die nötigen, starken Ströme erzeugen zu können, weist ein Gradientenspulensystem üblicherweise auch Leistungsverstärker auf. Aufgrund der starken, schnell wechselnden Ströme des Gradientenspulensystems kommt es in Magnetresonanzeinrichtungen zu einer starken Geräuschentwicklung, die, insbesondere auch aufgrund der längeren Untersuchungsdauern, von vielen Patienten als äußerst störend empfunden wird und Beklemmungs- und Angstzustände von Patienten, beispielsweise aufgrund des engen Raums, verstärken kann. Schnell aufeinanderfolgende Magnetresonanzsequenzen mit unterschiedlichem Lärmpegel, beispielsweise eine EPI-Sequenz nach einer TSE-Sequenz, können den Patienten erschrecken und auch zu Bewegungsartefakten führen.

Obwohl es verschiedene Ansätze gibt, die Lärmentwicklung während einer Magnetresonanzuntersuchung zu reduzieren, erscheint eine vollständige Reduktion nach heutigem Stand eher unwahrscheinlich. Im Stand der Technik werden häufig Kopfhörer eingesetzt, um den Schalldruck der Geräusche des Gradientenspulensystems zu verringern und/oder zu kompensieren, wenn eine aktive Geräuschdämpfung stattfinden soll.

Im Stand der Technik wurde zudem vorgeschlagen, zur angenehmeren Gestaltung des Aufenthalts von Patienten in einer Magnetresonanzeinrichtung während der Magnetresonanzuntersuchung Musik auszuspielen, wobei beispielsweise kommerzielle und/oder sonstige Musikstücke verwendet werden können, die dem Geräuschpegel in der Magnetresonanzeinrichtung überlagert werden. So schlägt beispielsweise WO 2012/069979 A1 vor, Musik die Geräusche des Gradientenspulensystems übertönend auszuspielen. Dabei wird die ausgespielte Musik durch Videobilder unterstützt, die den Patienten von den Geräuschen der Magnetresonanzeinrichtung ablenken sollen und für eine Konzentration auf die überlagerte Musik sorgen sollen. Dort wird mithin vorgeschlagen, den Patienten möglichst stark von den Geräuschen der Magnetresonanzeinrichtung abzulenken.

In US 2011/0142250 A1 wird ein Klangverschönerungssystem für eine Magnetresonanzeinrichtung beschrieben, welches dazu dient, während der Untersuchung eines Patienten ein zu den Geräuschen der Gradientenspulen komplementäres Musikstück abzuspielen, welches hinsichtlich Tonart und/oder Tempo zu den Geräuschen der Gradientenspulen passt. Die komplementären Musikstücke werden im Vorfeld für spezifische Gradientenspulensequenzen generiert, so dass während einer Untersuchung entsprechende Musikstücke ausgewählt und dem Patienten über einen Lautsprecher oder einen Kopfhörer vorgespielt werden können. Dabei kann eine Anpassung des Tempos und/oder der Tonart des Musikstückes im Vorfeld oder in Echtzeit eingestellt werden, um das Musikstück sowohl rhythmisch als auch harmonisch zu einer spezifischen Gradientensequenz zu synchronisieren.

In der Veröffentlichung "MR Synchronous Music" von Dr. Stefan Popescu, veröffentlicht in Journal Technik Up2date #06 sowie im Internet erhältlich, DOI: 10.4421/PAPDEOTT001085, wird vorgeschlagen, die üblicherweise von der Magnetresonanzeinrichtung erzeugten Geräusche des Gradientenspulensystems mit einer speziellen Zusatzgeräuschausgabe zu kombinieren, und zwar derart, dass insgesamt ein harmonisches Geräusch oder eine harmonische Musik entsteht. Dieser Vorschlag beruht auf der praktischen Feststellung, dass in Kontrast zu laut hämmernden akustischen Geräuschen laute harmonische Geräusche oder laute Musik nicht stresserzeugend auf Patienten wirkt, sondern eher entspannend. Hierzu kommt, dass laute harmonische Geräusche oder laute Musik weniger gefährlich für das menschliche Gehör ist, zumindest, wenn sie nur über einen begrenzten Zeitraum stattfinden. Die vorgeschlagene Lösung beruht auf harmonischer Synchronisierung und Schalldruckanpassung, die beide optimal kombiniert werden, um harmonische akustische Effekte oder ein bekanntes Musikstück erschaffen zu können. Die Magnetresonanzgeräusche werden also nicht überlagernd, sondern als Teil der lauten harmonischen Geräusche oder Musik eingesetzt, beispielsweise als Beiträge zum Beat, Rhythmus oder Tempo der Gesamtmelodie. Konkret wird vorgeschlagen, ein mehrdimensionales Modell eines harmonischen Geräuschs mit Beiträgen grundlegender musikalischer Deskriptoren zu bestücken, die durch Fourieranalyse aus den Gradientenspulengeräuschen der Magnetresonanzeinrichtung abgeleitet werden können, so dass dann auf Basis dieses Modells eine Musikdatenbank nach einem harmonisch passenden Musikstück durchsucht werden kann. Patientenpräferenzen können berücksichtigt werden.

Probleme treten bei der Anwendung dieses Vorschlags auf, da die meisten bekannten Musikstücke in einem gewissen Takt, beispielsweise 120 Beats pro Minute, kombiniert sind, was eine Synchronisation deutlich erschwert, insbesondere dann, wenn sich charakteristische Zeiten, insbesondere die Repetitionszeit TR, innerhalb des Aufnahmeprotokolls der Magnetresonanzeinrichtung ändern bzw. von Patient zu Patient angepasst werden.

Der Erfindung liegt daher die Aufgabe zugrunde, eine Möglichkeit zur Synchronisierung von Geräuschen eines Gradientenspulensystems und diese ergänzenden Geräuschen anzugeben, die insbesondere auch bei häufig wechselnden und/oder einen weiten Bereich abdeckenden entstehenden Takten der Geräusche des Gradientenspulensystems eingesetzt werden kann.

Zur Lösung dieser Aufgabe sind bei einer Magnetresonanzanlage der eingangs genannten Art erfindungsgemäß die Merkmale des Anspruchs 1 sowie bei einem Verfahren der eingangs genannten Art die Merkmale des Anspruchs 13 vorgesehen.

Erfindungsgemäß wird mithin vorgeschlagen, die Magnetresonanzeinrichtung als eine Instrumenteinrichtung in ein Musiknetzwerk einzubinden, dessen insgesamt vorhandene Instrumenteinrichtungen unter Nutzung der Geräusche des Gradientenspulensystems ein lautes harmonisches Geräusch bzw. ein lautes harmonisches Musikstück erzeugen, mithin die ohnehin vorhandenen Geräusche einer Magnetresonanzuntersuchung in ein akustisches Gesamtbild einpflegen, das zur Beruhigung des Patienten und zur Schonung des Gehörs beiträgt. Dabei wird eine Synchronisationseinheit verwendet, die aus einem magnetresonanzinternen Triggerpuls, also dortigen Sequenzsteuersignalen, ein musikalisches Synchronisationssignal erzeugt, mit dem weitere Instrumenteinrichtungen als externe Klangerzeuger synchron zu einem Magnetresonanzprotokoll bzw. einer Magnetresonanzsequenz Geräusche ausgeben können. Dabei ist das Sequenzsteuersignal als magnetresonanzeinrichtungsinterner Triggerpuls inhärent mit dem Sequenzframework synchronisiert.

Mit anderen Worten kann also die Magnetresonanzeinrichtung, in der das Wissen über die entstehenden Geräusche des Gradientenspulensystems vorliegt, als eine Art "Clock Master" zur Synchronisierung der Instrumenteinrichtungen des Musiknetzwerks verwendet werden. Dies ermöglicht es, auf die Magnetresonanzsequenz bzw. das Magnetresonanzprotokoll abgestimmte, synchronisierte Musik zu generieren, die quasi als eine Art "Magnetresonanz-Soundtrack" verstanden werden kann. Die Synchronisationseinheit als Schnittstelle zum Musiknetzwerk erzeugt das Synchronisationssignal, das auch als Clock-Signal verstanden werden kann, und stellt sicher, dass ein bestimmtes akustisches Muster immer zur richtigen Stelle abgespielt wird, mithin eine optimale Übereinstimmung mit den im Rahmen des Magnetresonanzprotokolls entstehenden Geräusch des Gradientenspulensystems gegeben ist. Dies erlaubt es, dem Patienten ein deutlich angenehmeres Gefühl während der Magnetresonanzuntersuchung zu vermitteln und insbesondere auch sein Gehör zu schonen.

Mit besonderem Vorteil wird das Musiknetzwerk mit einem standardisierten Kommunikationsprotokoll betrieben. Besonders bevorzugt ist es dabei, wenn die Kommunikation in dem Musiknetzwerk nach dem MIDI-Standard erfolgt. Der MIDI-Standard hat sich über die letzten Jahrzehnte in der Musikindustrie etabliert. Ausgehend von Sequenzsteuersignalen kann dann im Rahmen der Erfindung ein MIDI TIMING CLOCK-Signal als Synchronisationssignal generiert werden. Dieses kann beispielsweise 24mal oder 48mal pro Viertelnote gesendet werden. Über dieses MIDI TIMING CLOCK-Signal kann die Geschwindigkeit synchronisiert werden, mit der beispielsweise die den Geräuschen des Gradientenspulensystems hinzuzufügenden Geräusche bzw. Klänge abgespielt werden.

Die Steuereinrichtung kann bevorzugt eine Sequenzsteuereinheit zum Aussenden der insbesondere als TTL-Triggersignale ausgebildeten Sequenzsteuersignale aufweisen. Sequenzsteuereinheiten als Untereinheiten einer Steuereinrichtung einer Magnetresonanzeinrichtung können beispielsweise auch als "sequence and timing controller" bezeichnet werden. Erfindungsgemäß nutzen die davon ausgehenden Sequenzsteuersignale nicht nur mit dem Ausspielen der Magnetresonanzsequenz betraute Subsysteme der Magnetresonanzeinrichtung, sondern auch die Synchronisationseinheit, welche im Übrigen auch als Teil der Steuereinrichtung ausgebildet sein kann. Nachdem die Sequenzsteuersignale, welche die Triggersignale für weitere Komponenten der Magnetresonanzeinrichtung darstellen, unmittelbar beschreiben, wie und wann das Gradientenspulensystem angesteuert wird, folgt daraus auch, dass zweckmäßig die durch die Synchronisationseinheit ausgewerteten Sequenzsteuersignale durch das Gradientenspulensystem erzeugte, in dem Musikstück zu verwendende Geräusche beschreiben.

Erfindungsgemäß ist vorgesehen, dass die Synchronisationseinheit zum Erzeugen von Musiksteuersignalen an andere Instrumenteinrichtungen des Musiknetzwerks als oder zusätzlich zu den Synchronisationssignalen ausgebildet ist. Es kann mithin vorgesehen sein, dass die Magnetresonanzeinrichtung als Instrumenteinrichtung im Musiknetzwerk nicht nur die Rolle eines Clock Masters aufweist, sondern auch insgesamt die Rolle eines Masters, wobei die wenigstens eine weitere Instrumenteinrichtung die Rolle eines Slaves einnimmt. Steuersignale können dabei eine Vielzahl von Komplexitäten aufweisen. Synchronisationssignale, die auch als Musiksteuersignale dienen, umfassen dabei beispielsweise Startsignale, Stoppsignale, einen Positionszeiger angebende Signale, Pausesignale und Fortsetzungssignale. Wird der MIDI-Standard verwendet, existieren hier beispielsweise entsprechende START-, STOP- und CONTINUE-Signale, die entsprechend eingesetzt werden können, um beispielsweise einen Klangerzeuger synchron zu stoppen und erneut zu starten, wenn die Magnetresonanzuntersuchung unterbrochen wird. Allgemein können die Musiksteuersignale mithin einen Startbefehl und/oder einen Endbefehl und/oder einen Pausebefehl und/oder einen Fortsetzungsbefehl umfassen, wobei die Synchronisationseinheit zur Erzeugung der Musiksteuersignale in Einklang mit dem Ablauf unterschiedlicher Gradientengeräuschabschnitte in einem Sequenzablauf, die insbesondere Sequenzabschnitten bzw. einzelnen Magnetresonanzsequenzen mit fester Repetitionszeit entsprechen können, ausgebildet ist.

Die Magnetresonanzeinrichtung steuert im Musiknetzwerk also die anderen Instrumenteinrichtungen, um gemeinsam mit den Geräuschen des Gradientenspulensystems ein akustisches, harmonisches Gesamtbild, insbesondere ein Musikstück, zu erzeugen. Weitere Steuersignale in diesem Kontext können dabei selbstverständlich auch die durch die wenigstens eine weitere Instrumenteinrichtung auszugebenden Geräusche selbst beschreiben, beispielsweise als Klänge/Musiknoten/Klangfolgen und dergleichen.

So kann in einer bevorzugten Ausgestaltung der vorliegenden Erfindung auch vorgesehen sein, dass die Steuereinrichtung und/oder die Synchronisationseinheit zur Ermittlung abzuspielender, Geräusche des Gradientenspulensystems nutzender Musikstücke ausgebildet sind, wobei die Synchronisationseinheit zur Ausgabe von die Musikstücke und/oder die aktuell seitens der wenigstens einen weiteren Instrumenteinrichtung auszugebenden Geräusche des Musikstücks beschreibenden Musiksteuersignalen ausgebildet ist. Mithin können die musikalischen Inhalte des akustischen Gesamtbilds durch die Steuereinrichtung und/oder die Synchronisationseinheit ermittelbar sein, wobei die wenigstens eine weitere Instrumenteinrichtung entsprechend unter Nutzung des Musiknetzwerks angesteuert werden kann, um das akustische Gesamtbild als Musikstück tatsächlich zu erhalten. Dabei sind zwei grundsätzliche Ausgestaltungen denkbar, wie das Musikstück und somit die durch die weitere Instrumenteinrichtung auszugebenden Geräusche ermittelt werden können.

So ist es zum einen möglich, dass das Musikstück in Abhängigkeit zu erzeugender Gradientenpulse aus einer Datenbank ausgewählt wird. Hierbei kann beispielsweise vorgesehen sein, dass aus den im Rahmen einer Magnetresonanzuntersuchung ja im Voraus bekannten Gradientenpulsen bereits die Geräusche des Gradientenspulensystems, die erzeugt werden, vorausberechnet und analysiert werden, beispielsweise mittels einer FourierTransformation, um grundlegende musikalische Deskriptoren, insbesondere Beat, Tempo, Pitch und/oder Rhythmus, zu erhalten. Durch die musikalischen Deskriptoren entsteht dann ein Modell, welches in einer entsprechend annotierten musikalischen Datenbank genutzt werden kann, um ein passendes Musikstück aufzufinden, das ebenso die entsprechenden Deskriptoren aufweist bzw. nutzen kann, um durch Hinzufügung weiterer Geräusche ein harmonisches akustisches Gesamtbild zu erzielen.

In einer vorteilhaften Ausgestaltung ist es jedoch auch denkbar, dass das Musikstück mittels eines Generierungsalgorithmus seitens der Steuereinrichtung der Magnetresonanzeinrichtung in Abhängigkeit auszugebender Gradientenpulse erzeugt wird. Dabei wird mithin ein musikalischer Inhalt automatisch erzeugt, wobei ausgenutzt wird, dass bereits entsprechende Generierungsalgorithmen im Stand der Technik vorgeschlagen wurden, beispielsweise unter dem Stichwort "Arpeggiator". Es wurde auch vorgeschlagen, melodische Phrasen basierend auf festgelegten/generierten Akkordfolgen zu erzeugen, wobei hierfür beispielhaft auf das KARMA-Musikarbeitsgerät von Cork Industries verwiesen sei.

Erfindungsgemäß ist vorgesehen, dass die Synchronisationseinheit zur Ausgabe eines die Lautstärke der Ausgabe der wenigstens einen weiteren Instrumenteinrichtung vorbereitend auf einen vorausbestimmten Lautstärkesprung der Geräusche des Gradientenspulensystems in glattem Verlauf erhöhendem Musiksteuersignals ausgebildet ist, insbesondere derart, dass zum Zeitpunkt des Sprungs die Lautstärke der weiteren Instrumenteinrichtung zumindest im Wesentlichen die Lautstärke des Geräuschs des Gradientenspulensystems nach dem Lautstärkesprung erreicht hat. Insbesondere kann hierbei die Lautstärke linear ansteigend erhöhbar sein. Durch die Möglichkeit zur Steuerung seitens der Magnetresonanzeinrichtung kann mithin der musikalische Inhalt, der durch das Musiknetzwerk insgesamt ausgegeben wird, so ausgestaltet werden, dass starke Sprünge in der Lautstärke, beispielsweise zwischen zwei Magnetresonanzsequenzen, akustisch "vorweggenommen" werden, das bedeutet, das Ohr des Patienten wird vor dem eigentlichen Sprung der Lautstärke durch die Gradientenspulen bereits auf den kommenden Anstieg der Lautstärke vorbereitet. Es findet mithin eine akustische Impedanzanpassung des Ohres statt. Auf diese Weise können insbesondere ein Erschrecken des Patienten und potentiell hierdurch ausgelöste Patientenbewegungen verhindert werden. In einem glatten Verlauf wird die Amplitude, also Lautstärke, glatt vor dem Übergang zu einer neuen Magnetresonanzsequenz bzw. einem sonstigen Lautstärkesprung angepasst, um das Ohr auf den Lautstärkesprung vorzubereiten.

Eine bevorzugte Weiterbildung der Erfindung sieht vor, dass die Synchronisationseinheit in Abhängigkeit eines Tempos des Grundschlags des Musikstücks zur Ratenanpassung der Ausgabe der Synchronisationssignale ausgehend von der durch die Sequenzsteuersignale beschriebenen Repetitionszeit derart ausgebildet ist, dass der Zeitabstand der Ausgabe der Synchronisationssignale ein Vielfaches der Repetitionszeit oder umgekehrt ist. Die Synchronisationseinheit setzt damit eine Ratenanpassung zwischen dem Sequenz-Timing, insbesondere beschrieben durch die Repetitionszeit, und dem Musikstück-Basisrhythmus ("natural beat clock") um. Das bedeutet also, dass dann, wenn die Repetitionszeit bzw. die sich dadurch ergebende Wiederholrate höher ist als die "beat clock", die Synchronisationseinheit eine Dezimierung umsetzt, also eine Ratenreduktion, und beispielsweise ein Synchronisationssignal nur alle n, wobei n eine natürliche Zahl ist, Repetitionszeiten erzeugt. Beispielsweise kann n 2, 3 oder auch 10 betragen. Ist jedoch die sich aus der Repetitionszeit ergebende Wiederholrate deutlich niedriger als jene des Musikstücks, setzt die Synchronisationseinheit eine Multiplizierung der Repetitionszeit-Rate um, beispielsweise unter Verwendung einer PLL-Baueinheit (phase locked loop), um n gleichmäßig verteilte Synchronisationssignale im Zeitraum zwischen zwei Repetitionszeit-Sequenzsteuersignalen zu erzeugen, wobei n wiederum eine natürliche Zahl ist und beispielsweise 2, 3 oder 10 betragen kann.

In einer weiteren besonders vorteilhaften Ausgestaltung der vorliegenden Erfindung kann vorgesehen sein, dass an das Musiknetzwerk auch wenigstens eine Signale der Synchronisationseinheit zur Lichterzeugung auswertende Lichterzeugungseinrichtung angeschlossen ist. Mithin können die Synchronisationssignale auch verwendet werden, um beispielsweise eine Raumbeleuchtungseinrichtung und/oder eine Projektionseinrichtung zu steuern, beispielsweise ein sogenanntes "Mood-Display", welches bislang nicht synchronisiert zur Magnetresonanzuntersuchung verwendet wird. Bei der funktionellen Magnetresonanzbildgebung, bei der es gegebenenfalls um die Reaktion auf bestimmte externe Stimulationen geht, können optische Stimulationen, insbesondere passend zum Musikstück, ebenso durch entsprechende Ansteuerung einer Lichterzeugungseinrichtung eingeblendet werden. Es ist mithin denkbar, über die so beschriebene enge Kopplung der Magnetresonanzsequenz und der audiovisuellen Anregung entsprechende emotionale Zustände zu erzeugen, wenn dies für die Magnetresonanzuntersuchung sinnvoll ist.

In einer konkreten Umsetzung kann vorgesehen sein, dass die Synchronisationseinheit eine das Steuersignal verarbeitende FPGA-Schaltung und/oder einen das Sequenzsteuersignal verarbeitenden Mikrocontroller aufweist, welche jeweils einen UART aufweisen. Ein UART (universal asynchronous receiver/transmitter) erlaubt eine Echtzeit-Umsetzung der Sequenzsteuersignale zu den Synchronisationssignalen und/oder gegebenenfalls Musiksteuersignalen. Entsprechend kann konkret vorgesehen sein, dass wenigstens eine weitere Instrumenteinrichtung einen Audioverstärker und einen an diesen angeschlossenen Lautsprecher umfasst.

Neben der Magnetresonanzanlage betrifft die vorliegende Erfindung auch ein Verfahren zum Betrieb einer Magnetresonanzanlage der erfindungsgemäßen Art, wobei die Synchronisationseinheit Synchronisationssignale für das Musiknetzwerk aus von einer Steuereinrichtung der Magnetresonanzeinrichtung erhaltenen Sequenzsteuersignalen wenigstens für das Gradientenspulensystem ableitet. Sämtliche Ausführungen bezüglich der erfindungsgemäßen Magnetresonanzanlage lassen sich analog auf das erfindungsgemäße Verfahren übertragen, so dass auch mit diesem die bereits genannten Vorteile erhalten werden können.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine Prinzipskizze einer erfindungsgemäßen Magnetresonanzanlage,
- Fig. 2: eine Synchronisierungseinheit, und
- Fig. 3: Graphen zur Erläuterung einer Anpassung der akustischen Impedanz des Ohres eines Patienten.

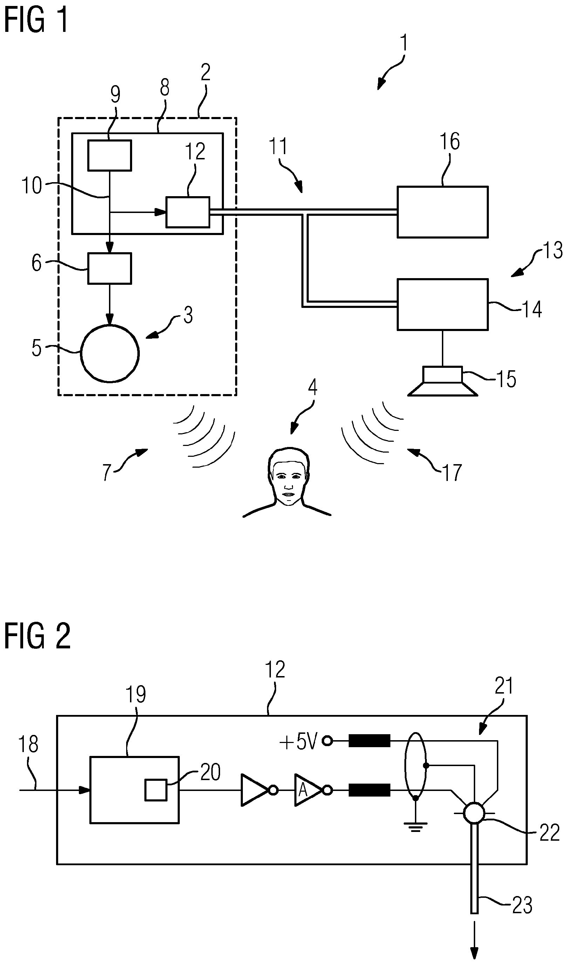

Fig. 1 zeigt eine funktionale Prinzipskizze einer erfindungsgemäßen Magnetresonanzanlage 1. Insbesondere bezüglich der Magnetresonanzeinrichtung 2 sind dabei weitere, für die Erfindung weniger relevante Komponenten der Übersichtlichkeit halber nicht näher dargestellt, insbesondere die Hauptmagneteinheit mit dem Grundfeldmagneten, ein Hochfrequenzspulensystem, ein Patientenlagerungssystem und dergleichen.

Zum Ermöglichen der Aufnahme von Magnetresonanzdaten eines bei 4 angedeuteten Patienten weist die Magnetresonanzeinrichtung 2 ein Gradientenspulensystem 3 mit Gradientenspulen 5 und einer entsprechenden Leistungselektronik 6, die einen Gradientenwellenformsynthesizer und Leistungsverstärker umfasst, auf. Bei Betrieb des Gradientenspulensystems 3 während einer Magnetresonanzuntersuchung, wenn also Teile einer Magnetresonanzsequenz ausgespielt werden, entstehen regelmäßige, laute Geräusche 7. Die Umsetzung eines wenigstens eine Magnetresonanzsequenz umfassenden Magnetresonanzprotokolls erfolgt in einer Steuereinrichtung 8 der Magnetresonanzeinrichtung 2, die zur konkreten Ansteuerung weiterer Komponenten der Magnetresonanzeinrichtung 2, insbesondere auch des Gradientenspulensystems 3, eine Sequenzsteuereinheit aufweist, die entsprechende Sequenzsteuersignale, hier als TTL-Triggersignale, ausgibt, wie durch den Pfeil 10 angedeutet.

Um die akustische und allgemeine Atmosphäre für den Patienten 4 angenehmer zu gestalten und den Patienten 4, insbesondere sein Gehör, zu schützen, ist die Magnetresonanzeinrichtung 2 als eine erste Instrumenteinrichtung an ein Musiknetzwerk 11 angebunden. Die Schnittstelle zu diesem Musiknetzwerk 11, hier ein MIDI-Netzwerk, wird durch eine Synchronisationseinheit 12, die vorliegend Teil der Steuereinrichtung 8 ist, gebildet. Die Synchronisationseinheit 12 nimmt wenigstens an das Gradientenspulensystem 3 gerichtete Sequenzsteuersignale entgegen und wandelt diese in Synchronisationssignale und/oder Steuersignale nach den MIDI-Standard um, die in das Musiknetzwerk 11 weitergegeben werden, wo sie zur Synchronisierung mit wenigstens einer weiteren Instrumenteinrichtung 13, die hier einen Audioverstärker 14 und einen Lautsprecher 15 umfasst, sowie einer Lichterzeugungseinrichtung 16, insbesondere einer Projektionseinrichtung und/oder einer Stimmungslichteinrichtung, dienen.

Dabei wird die Magnetresonanzeinrichtung 2 mittels der Synchronisationseinheit 12 vorliegend nicht nur als Clock Master betrieben, sondern insgesamt als Master, wobei die wenigstens eine weitere Instrumenteinrichtung 13 und die Lichterzeugungseinrichtung 16 als Slaves anzusehen sind.

Diesbezüglich erzeugt die Synchronisationseinheit 12 also auch in Einklang mit einem Sequenzablauf Musiksteuersignale. Die in das Musiknetzwerk 11 gegebenen Synchronisationssignale und/oder Musiksteuersignale stellen MIDI-Echtzeitnachrichten dar, die gemäß der MIDI 1.0-Spezifizierung der MIDI Manufacturers Association (MMA) ausgestaltet sind. Die Verwendung des MIDI-Standards sorgt dafür, dass alle MIDI-Einrichtungen, die angeschlossen sind, harmonisch zusammenwirken.

Beispielsweise können Sequenzsteuersignale der Sequenzsteuereinheit 9 in Sequenzen von zehn aufeinanderfolgenden Bits (ein Startbit, acht Datenbits und ein Stoppbit) umgewandelt werden, wobei die acht Datenbits verschiedene MIDI-Kommandos kodieren können. Insbesondere werden vorliegend wenigstens die MIDI-Steuersignale START, CONTINUE und STOP sowie die entsprechende "Timing clock", die beispielsweise 24mal pro Viertelnote gesendet wird, umgesetzt. Damit kann beispielsweise bei Unterbrechungen der Magnetresonanzsequenz bzw. des Magnetresonanzprotokolls auch eine Unterbrechung von Geräuschausgaben der wenigstens einen weiteren Instrumenteinrichtung 13 erfolgen.

Die Magnetresonanzeinrichtung 2 mittels des Gradientenspulensystems 3 sowie die wenigstens eine weitere Instrumenteinrichtung 13 sollen zusammen ein akustisches Gesamtbild in Form eines Musikstücks erschaffen, in welchem die Geräusche 7 des Gradientenspulensystems 3 um Geräusche 17 der wenigstens einen weiteren Instrumenteinrichtung 13 ergänzt werden, so dass ein harmonisches Musikstück entsteht, das der Patient 4 positiver wahrnimmt als allein die Geräusche 7 des Gradientenspulensystems 3.

Hierbei wird ausgenutzt, dass aufgrund des regelmäßigen Zeitablaufs jeglicher Magnetresonanzsequenz die Geräusche 7 einem repetitiven akustischen Muster entsprechen, welches eine Periode aufweist, die der Repetitionszeit TR entspricht, beispielsweise ähnlich zu einem Dröhnen, Summen oder Hämmern. Im musikalischen Ausdrücken kann das Geräusch 7 mit musikalischen Deskriptoren wie Beat, Tempo, Pitch oder Rhythmus assoziiert werden.

Die hier dargestellte Magnetresonanzanlage 1 nutzt einen parallelen Audiokanal, um synchron zu dem Geräusch 7 das Geräusch 17 zu überlagern, welches beispielsweise musikalische Deskriptoren hinsichtlich der Basismelodie, Akkorden, Progressionen, Oktaven, Timbre und dergleichen hinzufügen kann, um ein als akustisches Gesamtbild zu erzeugen, wobei der durch den Audioverstärker und den Lautsprecher 15 gebildete Geräuschsynthesizer im Slave-Modus konfiguriert ist und das Musikstück betrieben durch die MIDI-Synchronisationssignale und/oder Musiksteuersignale der Synchronisierungseinheit 12 ausgibt.

Musiksteuersignale der Synchronisationseinheit 12 können dabei auch die tatsächlich auszugebenden Geräusche 17 beschreiben, mithin über einfache Synchronisierungskommandos, wie beschrieben, hinausgehen, insbesondere dann, wenn die Steuereinrichtung 8 auch dazu ausgebildet ist, das Musikstück selbst aufgrund der auszugebenden Gradientenpulse festzulegen. Hierbei existieren im Wesentlichen zwei Möglichkeiten. Zum einen können die musikalischen Deskriptoren des Geräuschs 7, wie erläutert, abgeleitet werden, um ein Modell des Geräuschs 7 zu erzeugen, zu welchem passende Musikstücke aus einer musikalischen Datenbank abgerufen werden können, denen entsprechende Daten zum Abgleich zugeordnet sind. Dabei können auch Patientenpräferenzen, beispielsweise hinsichtlich von Musikrichtungen, berücksichtigt werden.

Denkbar ist es alternativ oder zusätzlich jedoch auch, dass das Musikstück seitens der Steuereinrichtung 8 selbst erstellt wird, beispielsweise auf Grundlage entsprechender, grundsätzlich bekannter Erzeugungsalgorithmen, so dass letztendlich eine Art eigener Magnetresonanz-Soundtrack entsteht. Auch hier kann entsprechend auf externe Ressourcen zurückgegriffen werden.

Dabei sei an dieser Stelle noch darauf hingewiesen, dass das Tempo der Ausgabe der Synchronisationssignale nicht zwangsläufig der sich aus der Repetitionszeit ergebenden Wiederholrate entsprechen muss, sondern eine Dezimierung bzw. Multiplizierung seitens der Synchronisationseinheit 12, beispielsweise über eine PLL-Einrichtung, als Ratenanpassung erfolgen kann. Mit anderen Worten ist die Synchronisationseinheit 12 in Abhängigkeit eines Tempos des Grundschlags des Musikstücks zur Ratenanpassung der Ausgabe der Synchronisationssignale ausgehend von der durch die Sequenzsteuersignale beschriebenen Repetitionszeit ausgebildet.

Die angeschlossene Lichterzeugungseinrichtung 16 kann dabei zur passenden optischen Untermalung des Musikstücks dienen; sie kann jedoch auch gezielt eingesetzt werden, um gemeinsam mit der Musik bestimmte emotionale Zustände herbeizuführen, die als Stimulation beispielsweise bei einer funktionalen Magnetresonanzbildgebung (fMRI) zweckmäßig sind.

Fig. 2 zeigt schematisch eine beispielhafte, konkrete Ausgestaltung der Synchronisationseinheit 12, die über einen Eingang gemäß dem Pfeil 18 Sequenzsteuersignale entgegennimmt. Diese durchlaufen zunächst einen Steuerbaustein 19, der als FPGA-Schaltung und/oder als Microcontroller ausgebildet sein kann. Der Steuerbaustein 19 weist hierbei einen UART 20 zur Herstellung der Echtzeitfähigkeit auf. Die Ausgangssignale des Steuerbausteins 19 werden über eine entsprechende Elektronikschaltung 21 in die standardisierten MIDI-Synchronisationssignale und Musiksteuersignale umgesetzt, um über einen entsprechenden MIDI-Anschluss 22 auf ein MIDI-Kabel 23 in das Musiknetzwerk 11 gegeben werden zu können.

Ferner kann das Musiknetzwerk 11 auch genutzt werden, um eine Lautstärkeanpassung in Vorbereitung auf einen während der Magnetresonanzuntersuchung auftretenden Lautstärkesprung, beispielsweise beim Übergang einer Magnetresonanzsequenz zu einer anderen, vorzunehmen, das bedeutet durch ein klassisches Erhöhen der Lautstärke kann die akustische Impedanz des Ohrs des Patienten 4 vorbereitend angepasst werden, um ein Erschrecken des Patienten 4 zu vermeiden.

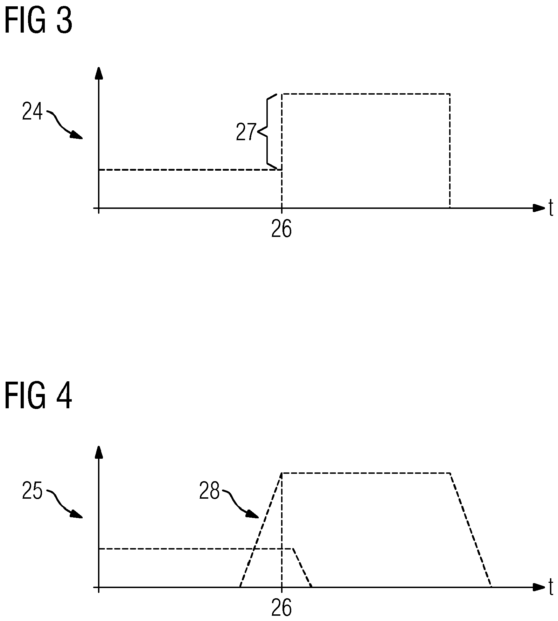

Dies ist in Fig. 3 näher erläutert, die im oberen Graphen 24 den erwarteten, vorausberechenbaren Lautstärkeverlauf des Geräuschs 7, im unteren Graphen 25 den Lautstärkeverlauf des Geräuschs 17 zeigt. Ersichtlich tritt zu einem Zeitpunkt 26 aufgrund eines Wechsels der Magnetresonanzsequenz, beispielsweise von einer EPI-Sequenz auf eine TSE-Sequenz, ein plötzlicher Lautstärkesprung 17 auf. Auf diesen kann das Gehör des Patienten 4 vorbereitet werden, indem für ein für die zweite Sequenz genutztes musikalisches Thema des Geräuschs 17 eine glatt, hier linear, ansteigende Lautstärke an der Flanke 28 gewählt wird, die zum Zeitpunkt 26, den Patienten 4 gewöhnend, den hohen Pegel bereits erreicht hat.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanzanlage (1) zur Magnetresonanzuntersuchung eines Patienten (4), aufweisend eine Magnetresonanzeinrichtung (2) mit einem Gradientenspulensystem (3), wobei die Magnetresonanzanlage (1) ferner ein Musiknetzwerk (11) mit wenigstens zwei kommunizierenden, durch über das Musiknetzwerk (11) gesendete Synchronisationssignale synchronisierten Instrumenteinrichtungen (13) zum Erzeugen eines an den Patienten (4) auszugebenden Musikstücks aufweist, wobei eine der Instrumenteinrichtungen (13) die Magnetresonanzeinrichtung (2) ist, welche als Schnittstelle an das Musiknetzwerk (11) eine Synchronisationseinheit (12) aufweist, welche zur Ableitung von Synchronisationssignalen für das Musiknetzwerk (11) aus von einer Steuereinrichtung (8) der Magnetresonanzeinrichtung (2) erhaltenen Sequenzsteuersignalen wenigstens für das Gradientenspulensystem (3) ausgebildet ist, **dadurch gekennzeichnet, dass** die Synchronisationseinheit (12) zum Erzeugen von Musiksteuersignalen an die wenigstens eine andere Instrumenteinrichtung (13) des Musiknetzwerks (11) als Synchronisationssignale oder zusätzlich zu den Synchronisationssignalen ausgebildet ist, wobei die Synchronisationseinheit (12) zur Ausgabe eines die Lautstärke der Ausgabe der wenigstens einen weiteren Instrumenteinrichtung (13) vorbereitend auf einen vorausbestimmten Lautstärkesprung (27) der Geräusche (7) des Gradientenspulensystems (3) in glattem Verlauf erhöhenden Musiksteuersignals ausgebildet ist.

2. Magnetresonanzanlage (1) nach Anspruch 1, **dadurch gekennzeichnet, dass** die Kommunikation in dem Musiknetzwerk (11) nach dem MIDI-Standard erfolgt.

3. Magnetresonanzanlage (1) nach Anspruch 1 oder 2, **dadurch gekennzeichnet, dass** die Steuereinrichtung (8) eine Sequenzsteuereinheit (9) zum Aussenden der insbesondere als TTL-Triggersignale ausgebildeten Sequenzsteuersignale aufweist und/oder die durch die Synchronisationseinheit (12) ausgewerteten Sequenzsteuersignale durch das Gradientenspulensystem (3) erzeugte, in dem Musikstück zu verwendende Geräusche (7) beschreiben.

4. Magnetresonanzanlage (1) nach einem der vorangehenden Ansprüche, **dadurch gekennzeichnet, dass** die Magnetresonanzeinrichtung (2) in dem Musiknetzwerk (11) die Rolle eines Masters aufweist, die restlichen Instrumenteinrichtungen (13) die eines Slaves.

5. Magnetresonanzanlage (1) nach einem der vorangehenden Ansprüche, **dadurch gekennzeichnet, dass** die Musiksteuersignale einen Startbefehl und/oder einen Endbefehl und/oder einen Pausebefehl und/oder einen Fortsetzungsbefehl umfassen, wobei die Synchronisationseinheit (12) zur Erzeugung der Musiksteuersignale im Einklang mit dem Ablauf unterschiedlicher Gradientengeräuschabschnitte in einem Sequenzablauf ausgebildet ist.

6. Magnetresonanzanlage (1) nach einem der vorangehenden Ansprüche, **dadurch gekennzeichnet, dass** die Steuereinrichtung (8) und/oder die Synchronisationseinheit (12) zur Ermittlung abzuspielender, Geräusche (7) des Gradientenspulensystems (3) nutzender Musikstücke ausgebildet sind, wobei die Synchronisationseinheit (12) zur Ausgabe von die Musikstücke und/oder die aktuell seitens der wenigstens einen weiteren Instrumenteinrichtung (13) auszugebenden Geräusche (17) eines der Musikstücke beschreibenden Musiksteuersignalen ausgebildet ist.

7. Magnetresonanzanlage (1) nach Anspruch 6, **dadurch gekennzeichnet, dass** die Steuereinrichtung (8) der Magnetresonanzeinrichtung (2)dazu ausgebildet ist, das Musikstück mittels eines Generierungsalgorithmus in Abhängigkeit auszugebender Gradientenpulse zu erzeugen und/oder in Abhängigkeit zu erzeugender Gradientenpulse aus einer Datenbank auszuwählen.

8. Magnetresonanzanlage (1) nach einem der vorangehenden Ansprüche, **dadurch gekennzeichnet, dass** die Synchronisationseinheit (12) derart ausgebildet ist, dass zum Zeitpunkt (26) des Sprungs (27) die Lautstärke der weiteren Instrumenteinrichtung (13) zumindest im Wesentlichen die Lautstärke des Geräuschs (7) des Gradientenspulensystems (3) nach dem Sprung (27) erreicht hat.

9. Magnetresonanzanlage (1) nach einem der vorangehenden Ansprüche, **dadurch gekennzeichnet, dass** die Synchronisationseinheit (12) in Abhängigkeit eines Tempos des Grundschlags des Musikstücks zur Ratenanpassung der Ausgabe der Synchronisationssignale ausgehend von der durch die Sequenzsteuersignale beschriebenen Repetitionszeit derart ausgebildet ist, dass der Zeitabstand der Ausgabe der Synchronisationssignale ein Vielfaches der Repetitionszeit oder umgekehrt ist.

10. Magnetresonanzanlage (1) nach einem der vorangehenden Ansprüche, **dadurch gekennzeichnet, dass** an das Musiknetzwerk (11) auch wenigstens eine Signale der Synchronisationseinheit (12) zur Lichterzeugung auswertende Lichterzeugungseinrichtung (16) angeschlossen ist.

11. Magnetresonanzanlage (1) nach einem der vorangehenden Ansprüche, **dadurch gekennzeichnet, dass** die Synchronisationseinheit (12) eine das Sequenzsteuersignal verarbeitende FPGA-Schaltung und/oder einen das Sequenzsteuersignal verarbeitenden Microcontroller aufweist, welche jeweils einen UART (20) aufweisen.

12. Magnetresonanzanlage (1) nach einem der vorangehenden Ansprüche, **dadurch gekennzeichnet, dass** die wenigstens eine weitere Instrumenteinrichtung (13) einen Audioverstärker (14) und einen an diesen angeschlossenen Lautsprecher (15) umfasst.

13. Verfahren zum Betrieb einer Magnetresonanzanlage (1) nach einem der vorangehenden Ansprüche, wobei die Synchronisationseinheit (12) Synchronisationssignale für das Musiknetzwerk (11) aus von einer Steuereinrichtung (8) der Magnetresonanzeinrichtung (2) erhaltenen Sequenzsteuersignalen wenigstens für das Gradientenspulensystem (3) ableitet und Musiksteuersignale an die wenigstens eine andere Instrumenteinrichtung (13) des Musiknetzwerks als Synchronisationssignale oder zusätzlich zu den Synchronisationssignalen (11) erzeugt, wobei die Synchronisationseinheit (12) vorbereitend auf einen vorausbestimmten Lautstärkesprung (27) der Geräusche (7) des Gradientenspulensystems (3) ein die Lautstärke der Ausgabe der wenigstens einen weiteren Instrumenteinrichtung (13) in glattem Verlauf erhöhendes Musiksteuersignal ausgibt.

## Claims

1. Magnetic resonance system (1) for the magnetic resonance examination of a patient (4), said magnetic resonance system having a magnetic resonance device (2) having a gradient coil system (3), wherein the magnetic resonance system (1) additionally has a music network (11) having at least two communicating instrument devices (13), synchronised by means of synchronisation signals sent via the music network (11), for generating a music piece that is to be output to the patient (4), wherein one of the instrument devices (13) is the magnetic resonance device (2) which, as interface to the music network (11), has a synchronisation unit (12) which is embodied for deriving synchronisation signals for the music network (11) from sequence control signals received from a control device (8) of the magnetic resonance device (2) at least for the gradient coil system (3), **characterised in that** the synchronisation unit (12) is embodied for generating music control signals to the at least one other instrument device (13) of the music network (11) as synchronisation signals or in addition to the synchronisation signals, wherein the synchronisation unit (12) is embodied for outputting a music control signal increasing the volume of the output of the at least one further instrument device (13) in a smooth progression in preparation for a predetermined jump in volume (27) of the noises (7) of the gradient coil system (3).

2. Magnetic resonance system (1) according to claim 1, **characterised in that** communications in the music network (11) are handled in accordance with the MIDI standard.

3. Magnetic resonance system (1) according to claim 1 or 2, **characterised in that** the control device (8) has a sequence control unit (9) for transmitting the sequence control signals embodied in particular as TTL trigger signals and/or the sequence control signals evaluated by the synchronisation unit (12) describe noises (7) generated by the gradient coil system (3) that are to be used in the music piece.

4. Magnetic resonance system (1) according to one of the preceding claims, **characterised in that** the magnetic resonance device (2) assumes the role of a master in the music network (11), the remaining instrument devices (13) that of a slave.

5. Magnetic resonance system (1) according to one of the preceding claims, **characterised in that** the music control signals comprise a start command and/or an end command and/or a pause command and/or a continue command, wherein the synchronisation unit (12) is embodied for generating the music control signals in unison with the execution of different gradient noise segments in a sequence execution.

6. Magnetic resonance system (1) according to one of the preceding claims, **characterised in that** the control device (8) and/or the synchronisation unit (12) are embodied for determining music pieces that are to be played using noises (7) of the gradient coil system (3), wherein the synchronisation unit (12) is embodied for outputting music control signals describing the music pieces and/or the noises (17) of the music piece that are currently to be output on the part of the at least one further instrument device (13).

7. Magnetic resonance system (1) according to claim 6, **characterised in that** the control device (8) of the magnetic resonance device (2) is embodied for generating the music piece by means of a generation algorithm as a function of gradient pulses that are to be output and/or for selecting said music piece from a database as a function of gradient pulses that are to be generated.

8. Magnetic resonance system (1) according to one of the preceding claims, **characterised in that** the synchronisation unit (12) is embodied in such a way that at the time instant (26) of the jump (27) the volume of the further instrument device (13) has reached at least substantially the volume of the noise (7) of the gradient coil system (3) following the jump in volume (27).

9. Magnetic resonance system (1) according to one of the preceding claims, **characterised in that** the synchronisation unit (12) is embodied for matching the rate of the output of the synchronisation signals as a function of a tempo of the pulse of the music piece, starting from the repetition time described by means of the sequence control signals, in such a way that the time interval of the output of the synchronisation signals is a multiple of the repetition time, or vice versa.

10. Magnetic resonance system (1) according to one of the preceding claims, **characterised in that** at least one light generation device (16) evaluating signals of the synchronisation unit (12) in order to generate light is also connected to the music network (11).

11. Magnetic resonance system (1) according to one of the preceding claims, **characterised in that** the synchronisation unit (12) has an FPGA circuit processing the sequence control signal and/or a microcontroller processing the sequence control signal, each of which has a UART (20).

12. Magnetic resonance system (1) according to one of the preceding claims, **characterised in that** the at least one further instrument device (13) comprises an audio amplifier (14) and a loudspeaker (15) connected thereto.

13. Method for operating a magnetic resonance system (1) according to one of the preceding claims, wherein the synchronisation unit (12) derives synchronisation signals for the music network (11) from sequence control signals received from a control device (8) of the magnetic resonance device (2) at least for the gradient coil system (3) and generates music control signals to the at least one other instrument device (13) of the music network as synchronisation signals or in addition to the synchronisation signals, wherein the synchronisation unit (12) outputs a music control signal increasing the volume of the output of the at least one further instrument device (13) in a smooth progression in preparation for a predetermined jump in volume (27) of the noises (7) of the gradient coil system (3).

## Revendications

1. Installation (1) de résonance magnétique pour l'examen d'un patient (4) par résonance magnétique, comportant un dispositif (2) de résonance magnétique ayant un système (3) de bobine de gradient, l'installation (1) de résonance magnétique ayant, en outre, un réseau (11) de musique ayant au moins deux dispositifs (13) d'instrument communiquant et synchronisés par des signaux de synchronisation envoyés par l'intermédiaire du réseau (1) de musique, afin de produire une pièce de musique à émettre vers le patient (4), l'un des dispositifs (13) d'instrument étant le dispositif (2) de résonance magnétique, qui a, comme interface avec le réseau (11) de musique, une unité (12) de synchronisation, qui est constituée pour la déduction de signaux de synchronisation du réseau (11) de musique à partir de signaux de commande de séquence, obtenus d'un dispositif (8) de commande du dispositif (2) de résonance magnétique, d'au moins le système (3) de bobine de gradient, **caractérisée en ce que** l'unité (12) de synchronisation est constituée pour produire, comme signaux de synchronisation ou supplémentairement aux signaux de synchronisation, des signaux de commande de musique sur le au moins un autre dispositif (3) d'instrument du réseau (11) de musique, l'unité (12) de synchronisation étant constituée pour l'émission d'un signal de commande de musique, élevant en courbe régulière l'intensité sonore de l'émission du au moins un autre instrument (13) de musique préparatoire à un saut (27) d'intensité sonore déterminé à l'avance du bruit (7) du système (3) de bobine de gradient.

2. Installation (1) de résonance magnétique suivant la revendication 1, **caractérisée en ce que** la communication dans le réseau (11) de musique s'effectue suivant la norme MIDI.

3. Installation (1) de résonance magnétique suivant la revendication 1 ou 2, **caractérisée en ce que** le dispositif (8) de commande a une unité (9) de commande de séquence pour l'envoi des signaux de commande de séquence, constitués notamment sous la forme de signaux de déclenchement TTL, et/ou les signaux de commande de séquence, exploités par l'unité (12) de synchronisation, décrivent des bruits (7) produits dans le système de bobine de gradient et à utiliser dans la pièce de musique.

4. Installation (1) de résonance magnétique suivant l'une des revendications précédentes, **caractérisée en ce que** le dispositif (2) de résonance magnétique a, dans le réseau (11) de musique, le rôle d'un maître, les dispositifs (13) d'instrument restant celui d'un esclave.

5. Installation (1) de résonance magnétique suivant l'une des revendications précédentes, **caractérisée en ce que** les signaux de commande de musique comprennent une instruction de début et/ou une instruction de fin et/ou une instruction de pause et/ou une instruction de continuation, l'unité (12) de synchronisation étant constituée pour la production des signaux de commande de musique en accord avec le déroulement de parties différentes de bruit de gradient suivant un déroulement en séquence.

6. Installation (1) de résonance magnétique suivant l'une des revendications précédentes, **caractérisée en ce que** les dispositifs (8) de commande et/ou l'unité (12) de synchronisation sont constitués pour la détermination de pièces de musique à jouer et utilisant des bruits (7) du système (3) de bobine de gradient, l'unité (12) de synchronisation étant constituée pour l'émission de signaux de commande de musique décrivant les pièces de musique et/ou les bruits (17) de l'une des pièces de musique, à émettre actuellement de la part du au moins un autre dispositif (13) d'instrument.

7. Installation (1) de résonance magnétique suivant la revendication 6, **caractérisée en ce que** le dispositif (8) de commande du dispositif (2) de résonance magnétique est constitué pour produire la pièce de musique au moyen d'un algorithme de production, en fonction d'impulsions de gradient à émettre, et/ou pour la choisir dans une base de données, en fonction d'impulsions de gradient à produire.

8. Installation (1) de résonance magnétique suivant l'une des revendications précédentes, **caractérisée en ce que** l'unité (12) de synchronisation est constituée de manière à atteindre, à l'instant (26) du saut (27) de l'intensité sonore de l'autre dispositif (13) d'instrument, au moins sensiblement, l'intensité sonore du bruit (7) du système (3) de bobine de gradient après le saut (27).

9. Installation (1) de résonance magnétique suivant l'une des revendications précédentes, **caractérisée en ce que** l'unité de synchronisation est constituée, en fonction du battement fondamental de la pièce de musique, pour l'adaptation de la fréquence de l'émission des signaux de synchronisation, à partir du temps de répétition décrit par les signaux de commande de séquence, de manière à ce que l'intervalle de temps de l'émission des signaux de synchronisation soit un multiple du temps de répétition ou inversement.

10. Installation (1) de résonance magnétique suivant l'une des revendications précédentes, **caractérisée en ce qu'**au réseau (11) de musique est raccordé également un dispositif (16) de production de lumière exploitant au moins un signal de l'unité de synchronisation pour une production de lumière.

11. Installation (1) de résonance magnétique suivant l'une des revendications précédentes, **caractérisée en ce que** l'unité (12) de synchronisation a un circuit FPGA traitant le signal de commande de séquence et/ou une micro-unité de commande traitant le signal de commande de séquence, qui ont chacune un UART (20).

12. Installation (1) de résonance magnétique suivant l'une des revendications précédentes, **caractérisée en ce que** le au moins un autre dispositif (13) d'instrument comprend un amplificateur (14) audio et un haut-parleur (15), qui y est raccordé.

13. Procédé pour faire fonctionner une installation (1) de résonance magnétique suivant l'une des revendications précédentes, l'unité (12) de synchronisation déduisant des signaux de synchronisation du réseau (11) de musique de signaux de commande de fréquence, obtenus d'un dispositif (8) de commande du dispositif (2) de résonance magnétique, d'au moins le système (3) de bobine de gradient et produisant, comme signaux de synchronisation ou supplémentairement aux signaux (11) de synchronisation, des signaux de commande de musique sur le au moins un autre dispositif (13) d'instrument du réseau de musique, l'unité (12) de synchronisation émettant, préliminairement à un saut (27) d'intensité sonore déterminé à l'avance des bruits (7) du système (3) de bobine de gradient, un signal de commande de musique élevant en courbe lisse l'intensité sonore de l'émission du au moins un autre dispositif (13) d'instrument.
